# EUROPEAN PATENT APPLICATION

(11) **EP 1 601 021 A1**
(43) Date of publication of application: **30.11.2005**
(21) Application number: 04714948.9
(22) Date of filing: 26.02.2004
(51) Int. Cl.: H01L 31/02

(54) **LEAD FRAME AND LIGHT RECEIVING MODULE COMPRISING IT**

(30) Priority: 27.02.2003 JP 2003050782; 09.05.2003 JP 2003131621
(71) Applicant: SANYO ELECTRIC COMPANY LIMITED, Moriguchi-shi, Osaka 570-0083 (JP); Tottori Sanyo Electric Co., Ltd., Tottori-shi, Tottori 680-8577 (JP)
(72) Inventor: TANAKA, Masao, Tottori Sanyo Electric Co., Ltd., Tottori-shi, Tottori 680-8634 (JP); MAETA, Susumu, Tottori Sanyo Electric Co., Ltd., Tottori-shi, Tottori 680-8634 (JP)
(74) Representative: Glawe, Delfs, Moll
(86) International application number: PCT/JP2004/002315
(87) International publication number: WO 2004/077575

(57) **Abstract**

On a leadframe on which to fix a photodetector element, an element mount frame and a fitting frame are laid with a gap left in between. A shielding frame for electromagnetically shielding the photodetector element is tied, via a tying portion, not to the element mount frame but to the fitting frame. Bending the tying portion brings it into a state in which it covers the photodetector element, but the stress resulting from this bending of the tying portion is shut off by the gap so as not to spread to the element mount frame. On the element mount frame, a circuit element for processing the signal from the photodetector element also is fixed.

## Description

### Technical field

The present invention relates to a leadframe, and to a photodetector module provided therewith.

### Background art

There have been developed a variety of appliances that can be remotely controlled. Many such appliances exchange remote-control signals in the form of optical signals of, for example, infrared rays. A photodetector module for receiving optical signals handles faint signals, and is therefore susceptible to electromagnetic noise. A well-known approach to shut off the influence of electromagnetic noise from a photodetector module is to use a shielding plate. How a shielding plate is used is disclosed, for example, in Japanese Patent Application Laid-Open No. H10-242487. Japanese Patent Application Laid-Open No. H10-242487 discloses the following structure. A frame on which a photodetector element is mounted is tied, via a tying portion with a smaller width, to a shielding plate. The tying portion is bent so that the shielding plate covers the photodetector element, and the shielding plate is kept at the ground potential so as to shut off electromagnetic noise.

In the structure disclosed in Japanese Patent Application Laid-Open No. H10-242487, the shielding plate is fixed to the photodetector element mount frame. Thus, when the tying portion is bent, the resulting stress is likely to spread to the photodetector element mount frame. Although the tying portion has a groove, opening, or the like formed therein so as to have as small a width as possible, still the bending stress spreads to the photodetector element mount frame. If this stress deforms the photodetector element mount frame, it acts as a factor that brings a change in the angle of the photodetector element. A deviation in the angle of the photodetector element from the design value leads to degraded photodetective characteristics. On the other hand, the heat dissipated from the photodetector element itself and from the circuit elements that process the signals therefrom also produces stress between the photodetector element mount frame and the shielding plate. This stress may cause cracks in the resin for molding.

### Disclosure of the invention

In view of the above problems, an object of the present invention is to provide, for a leadframe and for a photodetector module provided therewith, a structure in which unnecessary stress is unlikely to spread to an element mount frame when a shielding frame for covering the element mount frame is bent at a tying portion.

To achieve the above object, according to the present invention, a leadframe and a photodetector module provided therewith are given one of the following structures.

In a first structure, a leadframe is provided with an element mount frame, a fitting frame that is laid beside the element mount frame with a gap left in between, and a shielding frame that is tied via a tying portion to the fitting frame and that can be brought into such a state as to cover the element mount frame. With this structure, when the tying portion is bent, the resulting stress spreads to the fitting frame, but is less likely to spread to the element mount frame thanks to the gap left between it and the fitting frame. This prevents deformation of the element mount frame, thus prevents a change in the angle of the photodetector element, and thus prevents deterioration of the photodetective characteristics.

In a second structure, in the leadframe structured as described above, the tying portion is provided at both ends of the gap. With this structure, the leadframe has increased mechanical strength. Moreover, the trouble of connecting the element mount frame and the fitting frame together by a wire can be saved.

In a third structure, in the leadframe structured as described above, the element mount frame and the fitting frame are separate. With this structure, no part of the stress resulting from the bending of the tying portion of the shielding frame spreads to the element mount frame. Thus, deformation of the element mount frame can be completely prevented.

In a fourth structure, in the leadframe structured as described above, the fitting frame is, in a portion thereof near the tying portion, shaped symmetrically about the tying portion. With this structure, the stress resulting from the bending of the tying portion is equally distributed between both sides of the tying portion. That is, the stress never concentrates in one side to eventually spread to the element mount frame.

In a fifth structure, a photodetector module is provided with a photodetector element, an element mount frame on which the photodetector element is mounted, a fitting frame that is laid beside the element mount frame with a gap left in between, a shielding frame that is tied via a tying portion to the fitting frame and that can be brought into such a state as to cover the element mount frame, and molding resin in which the element mount frame and the fitting frame are sealed. With this structure, when the tying portion is bent, the resulting stress spreads to the fitting frame, but is less likely to spread to the element mount frame thanks to the gap left between it and the fitting frame. This prevents deformation of the element mount frame, thus prevents a change in the angle of the photodetector element, and thus prevents deterioration of the photodetective characteristics. Moreover, since the element mount frame and the fitting frame are sealed in the molding resin, the photodetector module has high mechanical strength, and is free from a change in the angle of the photodetector element.

In a sixth structure, in the photodetector module structured as described above, the element mount frame and the shielding frame are kept at an equal potential. With this structure, the element mount frame can function as a grounding frame.

In a seventh structure, in the photodetector module structured as described above, the element mount frame and the shielding frame are kept at different potentials. With this structure, the shielding frame, which is kept at a different potential, functions to shield electromagnetic noise.

In an eighth structure, in the photodetector module structured as described above, a circuit element that processes a signal from the photodetector element is mounted on the element mount frame. With this structure, the signal from the photodetector element can be processed under the shield provided by the shielding frame. Thus, even a faint signal can be processed without being influenced by electromagnetic noise.

In a ninth structure, in the photodetector module structured as described above, the element mount frame and the gap have nearly equal lengths. With this structure, unnecessary stress is unlikely to spread to the element mount frame. This helps realize a photodetector module with good photodetective characteristics.

### Brief description of drawings

Fig. 1 is a perspective view of the photodetector module of a first embodiment of the invention.
Fig. 2 is a front view of the photodetector module of the first embodiment.
Fig. 3 is a front view of the photodetector module of the first embodiment, with the molding resin removed.
Fig. 4 is a side view of the photodetector module of the first embodiment.
Fig. 5 is a bottom view of the photodetector module of the first embodiment.
Fig. 6 is a plan view of the leadframe used in the photodetector module of the first embodiment.
Fig. 7 is a plan view of the leadframe used in the photodetector module of the first embodiment, showing a portion thereof corresponding to a single photodetector module.
Fig. 8 is a plan view of the leadframe used in the photodetector module of the first embodiment, as observed at one stage in the course of the assembly thereof.
Fig. 9 is a plan view of the leadframe used in the photodetector module of the first embodiment, as observed at another stage, different from the one shown in Fig. 8, in the course of the assembly thereof.
Fig. 10 is a perspective view of the photodetector module of a second embodiment of the invention.
Fig. 11 is a front view of the photodetector module of the second embodiment.
Fig. 12 is a front view of the photodetector module of the second embodiment, with the molding resin removed.
Fig. 13 is a side view of the photodetector module of the second embodiment.
Fig. 14 is a bottom view of the photodetector module of the second embodiment.
Fig. 15 is a plan view of the leadframe used in the photodetector module of the second embodiment.
Fig. 16 is a plan view of the leadframe used in the photodetector module of the second embodiment, showing a portion thereof corresponding to a single photodetector module.
Fig. 17 is a plan view of the leadframe used in the photodetector module of the second embodiment, as observed at one stage in the course of the assembly thereof.
Fig. 18 is a plan view of the leadframe used in the photodetector module of the second embodiment, as observed at another stage, different from the one shown in Fig. 17, in the course of the assembly thereof.
Fig. 19 is a plan view of the leadframe used in the photodetector module of a third embodiment of the invention, as observed at one stage in the course of the assembly thereof.
Fig. 20 is a plan view of the leadframe used in the photodetector module of a fourth embodiment of the invention, as observed at one stage in the course of the assembly thereof.

### Best mode for carrying out the invention

Hereinafter, embodiments of the present invention will be described with reference to the accompanying drawings.

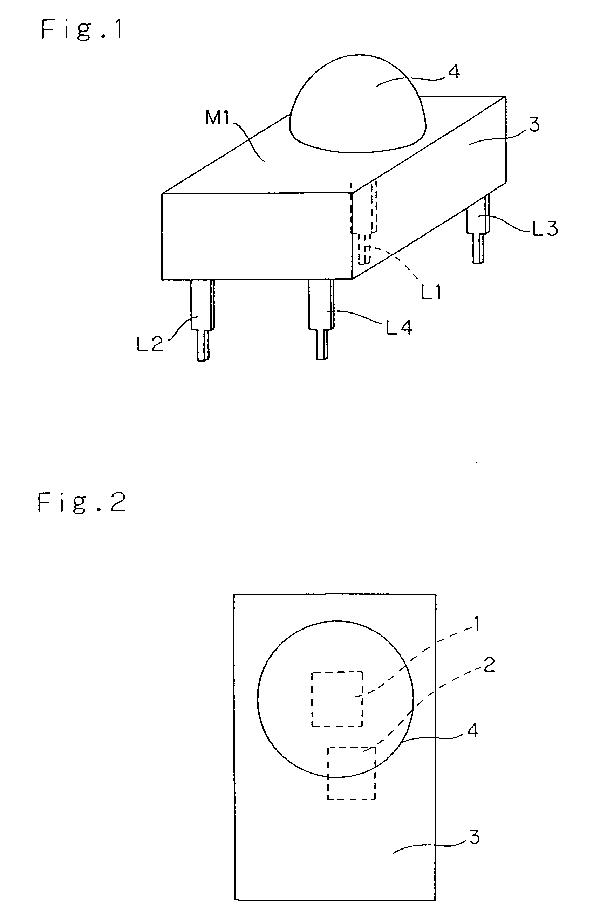

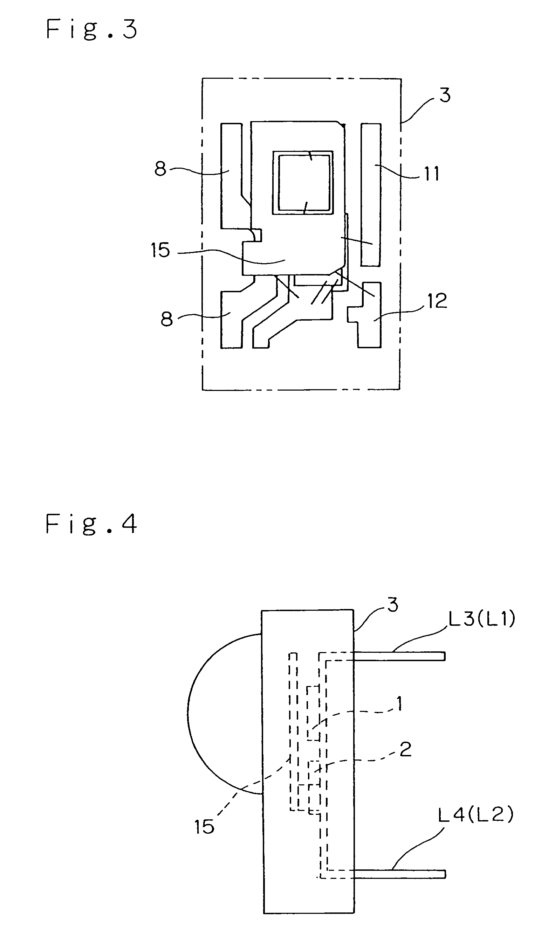

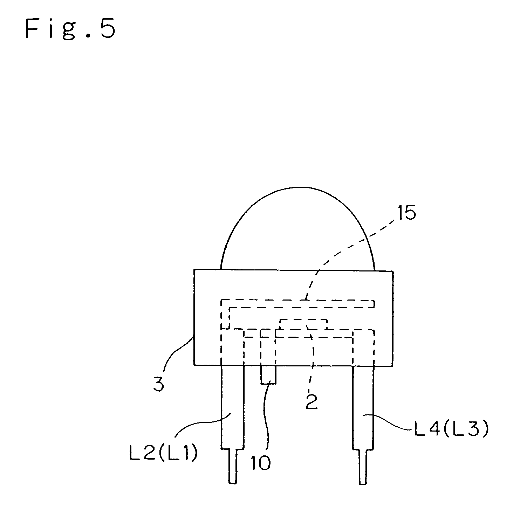

Figs. 1 to 5 show the photodetector module of a first embodiment of the invention. Fig. 1 is a perspective view, Fig. 2 is a front view, Fig. 3 is a front view with the molding resin removed, Fig. 4 is a side view, and Fig. 5 is a bottom view.

A photodetector module M1 is used in television monitors, air conditioners, and other appliances to receive remote control signals (infrared signals). The photodetector module M1 has a photodetector element 1 and, as a circuit for processing the signal therefrom, an integrated circuit 2 (hereinafter abbreviated to "IC 2") both sealed in a rectangular block of molding resin 3.

From the rear face of the molding resin 3 protrude four leads L1 to L4. The leads L1 to L4 are formed by bending parts of a leadframe F1, which will be described later.

The photodetector module M1 has the following structure. In a partial region on a metal leadframe F1, the photodetector element 1 and the IC 2 for processing the signal therefrom are mounted beside each other, and these are sealed into a single unit with the molding resin 3. The molding resin 3 is, at the front face thereof, about 10 mm high by about 6 mm wide, and has, on the front face thereof, a condenser lens 4 formed integrally therewith.

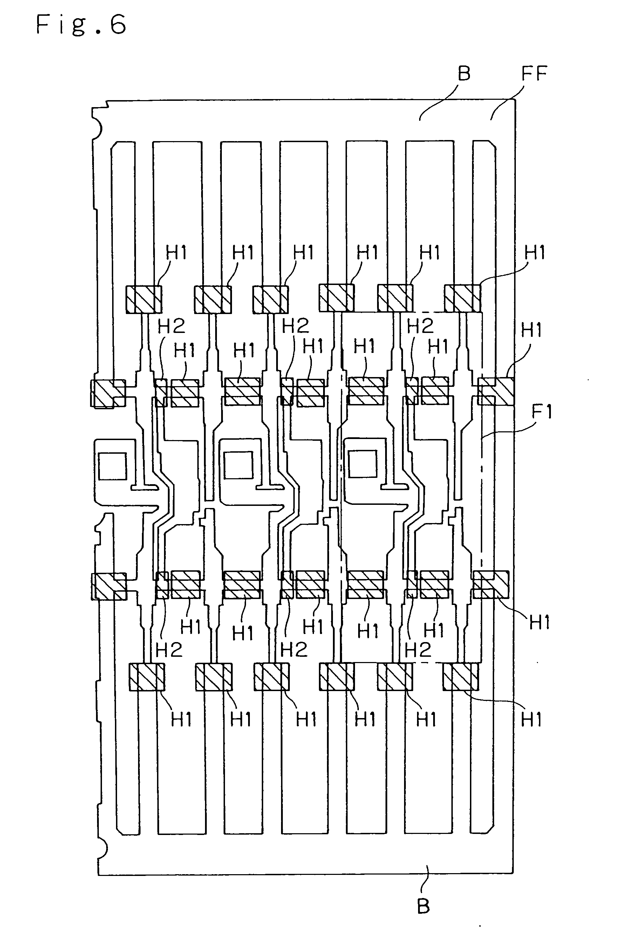

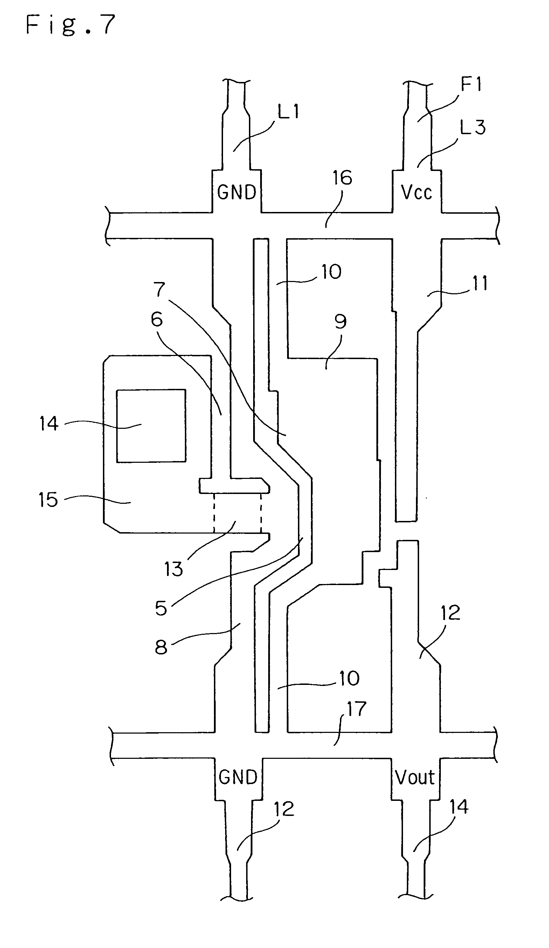

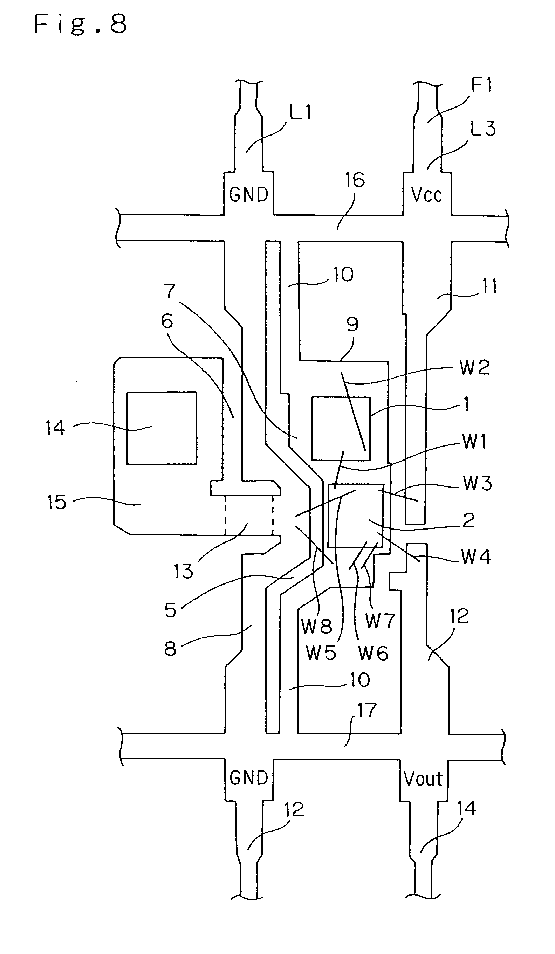

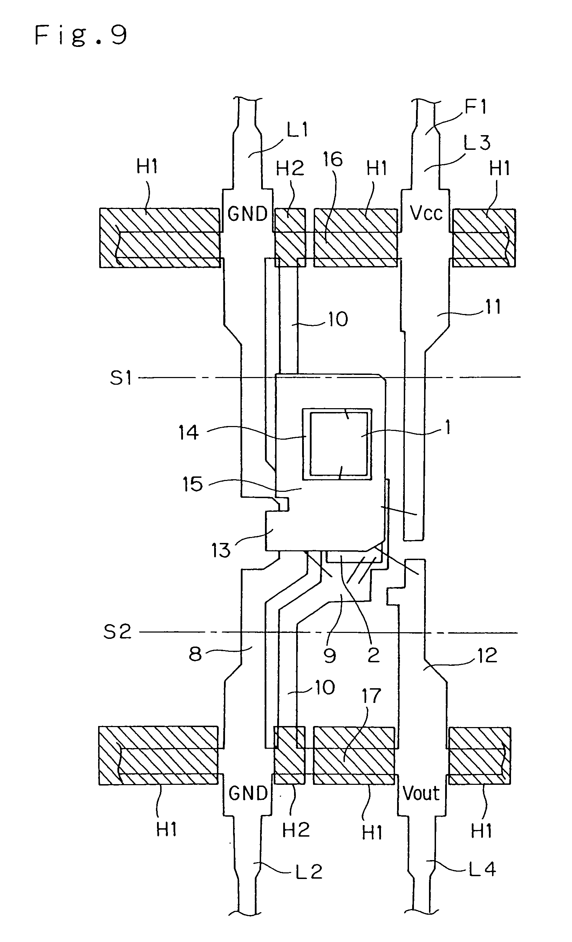

Next, with reference to the Figs. 6 to 9, which show the leadframe, the structure of the photodetector module M1 will be described along with the fabrication procedure thereof. Fig. 6 is a plan view of the leadframe, Fig. 7 is a plan view of the leadframe showing a portion thereof corresponding to a single photodetector module, Fig. 8 is a plan view of the leadframe as observed at one stage in the course of the assembly thereof, and Fig. 9 is a plan view of the leadframe as observed at another stage, different from the one shown in Fig. 8, in the course of the assembly thereof.

First, as partially shown in Fig. 6, a leadframe FF is prepared through punching of thin sheet metal. Fig. 7 shows the shape of the leadframe F1 that is used in a single photodetector module. The leadframe FF is an aggregate of a plurality of leadframes F1 that are tied together by tie bars B, each leadframe F1 shaped as shown in Fig. 7 and corresponding to a single photodetector module.

As shown in Figs. 3 and 7, along one of the longer sides of the molding resin 3 extends an elongate fitting frame 8, and from both ends thereof protrude the leads L1 and L2. The leads L1 and L2 are used for connection to the ground potential (GND), and thus the fitting frame 8 functions as a grounding frame.

An element mount frame 9, which has an element mount region thereon and has a comparatively large area, is laid parallel with the fitting frame 8. The fitting frame 8 and the element mount frame 9 form part of a main frame 7. In the main frame 7, between the fitting frame 8 and the element mount frame 9, a gap 5 is formed in the shape of an elongate groove or cut. The element mount frame 9 is, at both ends thereof, tied to both ends of the fitting frame 8 by tie bars 10, 16, and 17. In other words, a tying portion for tying the element mount frame 9 and the fitting frame 8 together is provided on both sides of the gap 5.

Along the other of the longer sides of the molding resin 3 extends an elongate power supply (Vcc) frame 11, and from one end thereof protrudes the lead L3. Likewise, along the other of the longer sides of the molding resin 3 extends, aligned with the power supply (Vcc) frame 11, a signal output (Vout) frame 12, and from one end thereof protrudes the lead L4.

In a position symmetric with the element mount frame 9 about the fitting frame 8, a shielding frame 15 is formed that has a window 14 formed therein and that has a comparatively large area. The shielding frame 15 is tied, via a tying portion 13, to a middle portion of the fitting frame 8. The fitting frame 8 is, in a portion thereof near the tying portion 13, shaped nearly symmetrically about the tying portion 13. Thus, as will be described later, when the tying portion 13 is bent, the resulting stress is equally distributed between both sides of the tying portion 13. Between the fitting frame 8 and the shielding frame 15, except in the tying portion 13, an elongate cut 6 is formed to separate the fitting frame 8 and the shielding frame 15 from each other. This helps give a smaller width to the tying portion 13, which functions as the very portion that is bent.

Between the tying portion 13 and the element mount frame 9 is left the gap 5. The length of the gap 5 is greater than any of the width of the tying portion 13, the length of the cut 6, the length of the element mount frame 9, and the length of the shielding frame 15. Here, all the "widths" and "lengths" mentioned are dimensions along the longer sides of the molding resin 3.

The leads L1 and L3, which are adjacent along the shorter sides of the molding resin 3, are tied together by the tie bar 16. Likewise, the leads L2 and L4, which are adjacent along the shorter sides of the molding resin 3, are tied together by the tie bar 17. The tie bars 10, 16, and 17 are, as will be described later, cut off by punching (indicated as hatched areas H1 and H2 in Figs. 6 and 9).

Fig. 8 shows the state in which the photodetector element 1 and the IC 2 for processing the signal therefrom are fixed on the element mount frame 9 with adhesive. As the adhesive here, both an insulating type and a conductive type are used as necessary. The photodetector element 1 and the IC 2 are connected together by a wire W1 for signal extraction. The photodetector element 1 and the element mount frame 9 are connected together by a wire W2 for grounding. The IC 2 and the power supply (Vcc) frame 11 are connected together by a wire W3 for power supply. The IC 2 and the signal output (Vout) frame 12 are connected together by a wire W4 for signal output. The IC 2, the fitting frame 8, and the element mount frame 9 are connected together by wires W5, W6, and W7 for grounding. The fitting frame 8 and the element mount frame 9 are connected together by a wire W8 for grounding.

After these wires are strung, as shown in Fig. 9, the tying portion 13 is bent so that the shielding frame 15 covers the element mount frame 9. As indicated by broken lines in Figs. 7 and 8, the tying portion 13 has two bending lines inscribed thereon at a predetermined interval so that it can be easily bent into a square-comered C-like shape. The stress resulting from this bending spreads via the tying portion 13 to the fitting frame 8, but not further to the element mount frame 9 thanks to the gap 5 left between the fitting frame 8 and the element mount frame 9. That is, the stress that acts on the main frame 7 when the tying portion 13 is bent is alleviated by the gap 5, which thereby shuts off the spreading of the stress to the element mount frame 9.

In the state with the tying portion 13 bent as shown in Fig. 9, the window 14 of the shielding frame 15 overlaps the photodetector element 1, permitting light to strike it. The photodetector element 1 is, except where it receives light, covered by the shielding frame 15. Moreover, the shielding frame 15 covers the greater part of the IC 2. Thus, the IC 2 can process the signal from the photodetector element 1 under the shield provided by the shielding frame 15. Hence, even when the signal is faint, it is unlikely to be influenced by electromagnetic noise.

Subsequently, along lines S1 and S2 shown in Fig. 9, the leads L1 to L4 are bent toward the rear face of the molding resin 3. Fig. 3 shows the state of the frame after the bending of the leads, as seen from in front. The stringing of the wires and the bending of the leads may be performed in reverse order, in which case first the leads L1 to L4 are bent and then the photodetector element 1 and the IC 2 are fixed, followed by the stringing of the wires.

Next, the leadframe is put in a molding frame filled with uncured resin, with the photodetector element 1 and the IC 2 facing down. When the resin cures, it forms the rectangular molding resin 3. The molding resin 3 holds the individual frames at regular intervals. This increases the mechanical strength of the photodetector module M1, and in addition makes it free from a change in the angle of the photodetector element 1.

Thereafter, the tie bars B and the tie bars 10, 16, and 17 are cut off in the hatched areas H1 and H2 shown in Figs. 6 and 9. Now, the fabrication of the photodetector module M1 shown in Figs. 1 to 5 is complete. The fitting frame 8 and the element mount frame 9 are cut apart from each other, but their relative positions are fixed by the molding resin 3, and their electrical connection is secured by the wire W8.

The element mount frame 9 is cut apart from the other frames. The destination of the wire W8 may be so changed that it is electrically connected to a frame other than the fitting frame 8.

In this embodiment, the element mount frame 9 and the fitting frame 8 are cut apart from each other. Alternatively, the tie bars 10, 16, and 17 may be left uncut so that the element mount frame 9 and the fitting frame 8 remain tied together by the tie bars 10, 16, and 17. Specifically, they are cut off only in the hatched area H1 shown in Fig. 9, and are left in the hatched area H2. This permits the element mount frame 9 and the fitting frame 8 to remain tied together by the tie bars 10, 16, and 17. This helps increase the mechanical strength of the element mount frame 9 and the fitting frame 8, and also helps save the trouble of securing electrical connection with the wire W8.

With the photodetector module M1 structured as described above, when the leads L1 to L4 are inserted in holes formed in a mount circuit board and fixed thereto, the photodetective surface lies parallel to the mount circuit board surface. When the photodetector module M1 receives light shone from a direction perpendicular to the mount circuit board surface, it produces a signal.

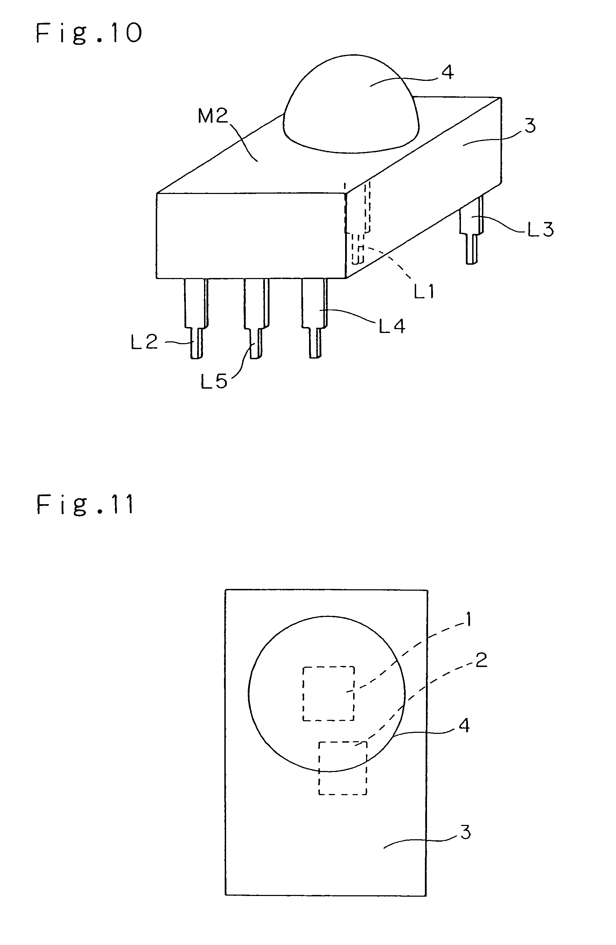

Next, the photodetector module of a second embodiment of the invention will be described with reference to Figs. 10 to 18. The following description places emphasis on differences from the first embodiment.

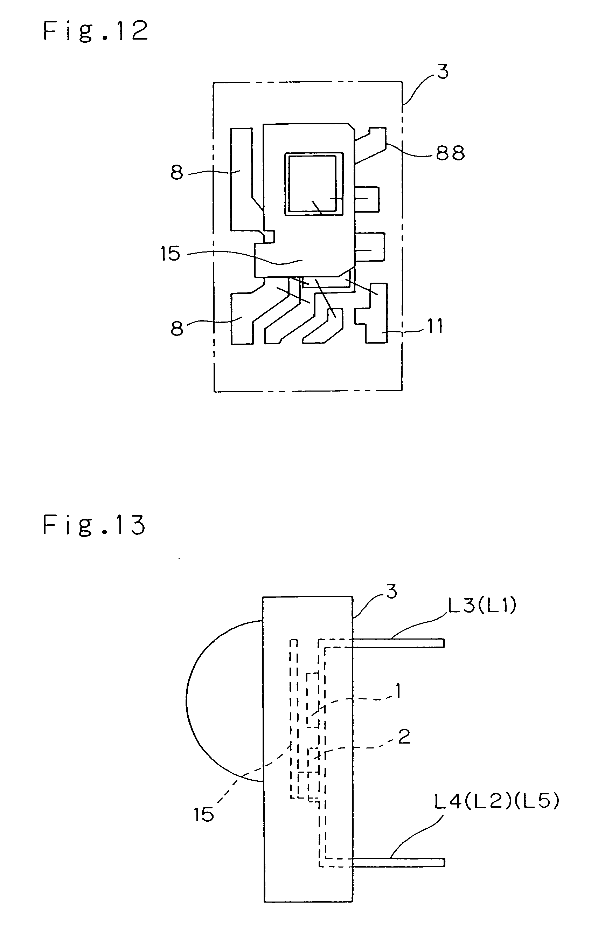

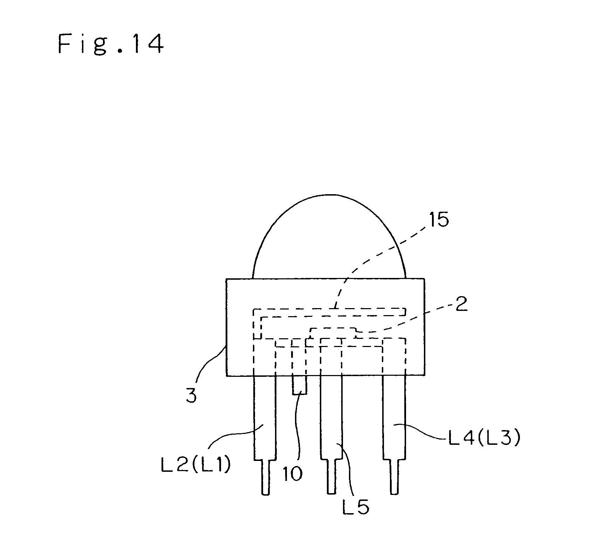

Fig. 10 is a perspective view of the photodetector module of the second embodiment, Fig. 11 is a front view, Fig. 12 is a front view with the molding resin removed, Fig. 13 is a side view, and Fig. 14 is a bottom view.

Like the photodetector module M1, a photodetector module M2 has a photodetector element 1 and, as a circuit for processing the signal therefrom, an IC 2 both sealed in a rectangular block of molding resin 3. From the rear face of the molding resin 3 protrude five leads L1 to L5. The leads L1 to L5 are formed by bending parts of a leadframe F2, which will be described later.

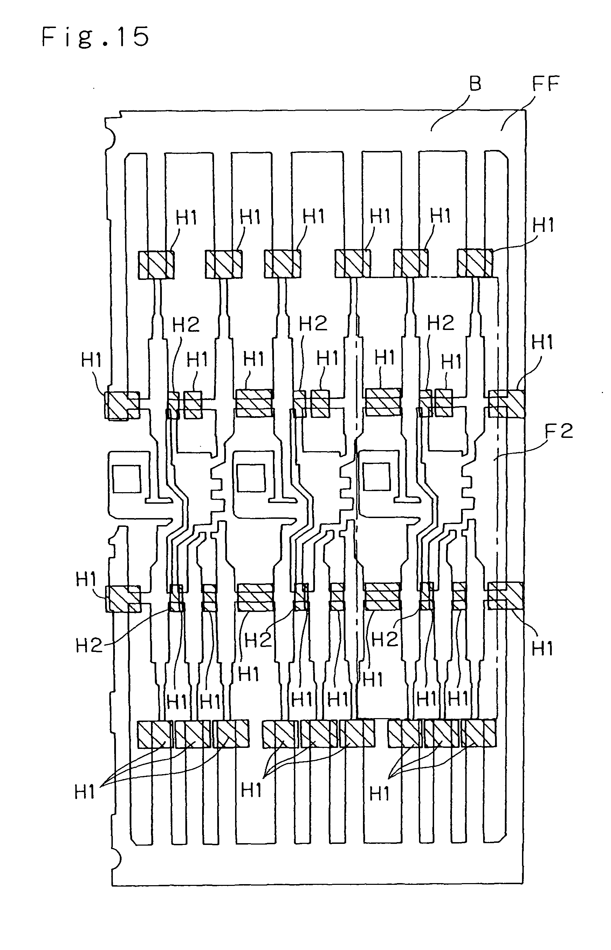

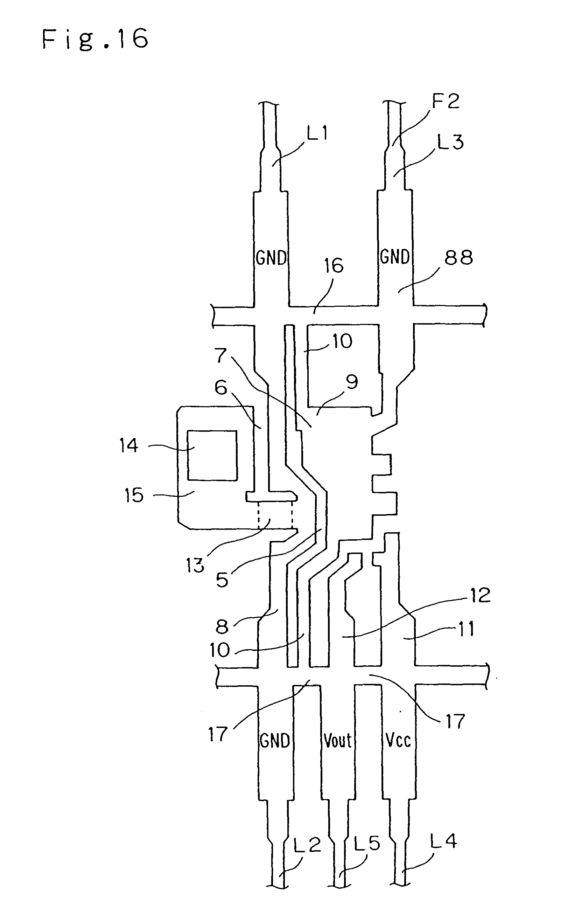

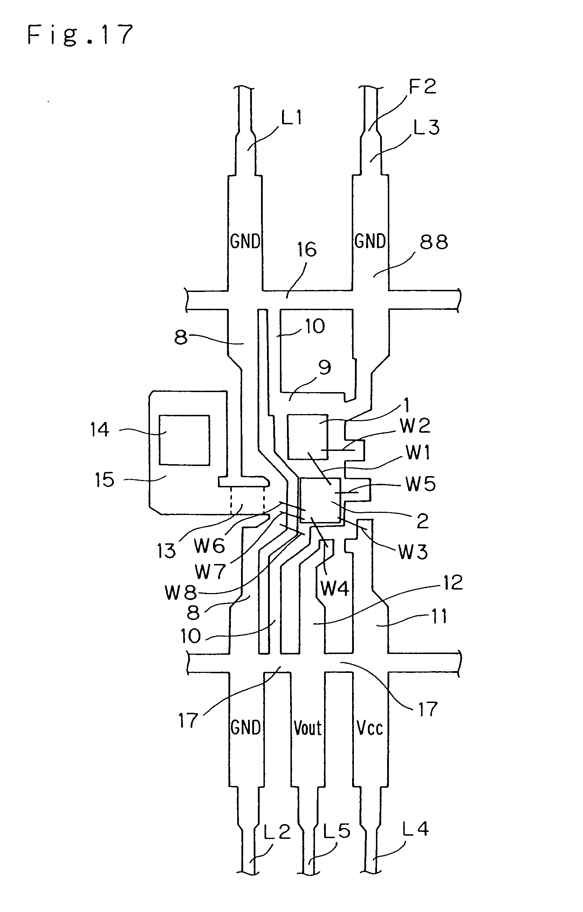

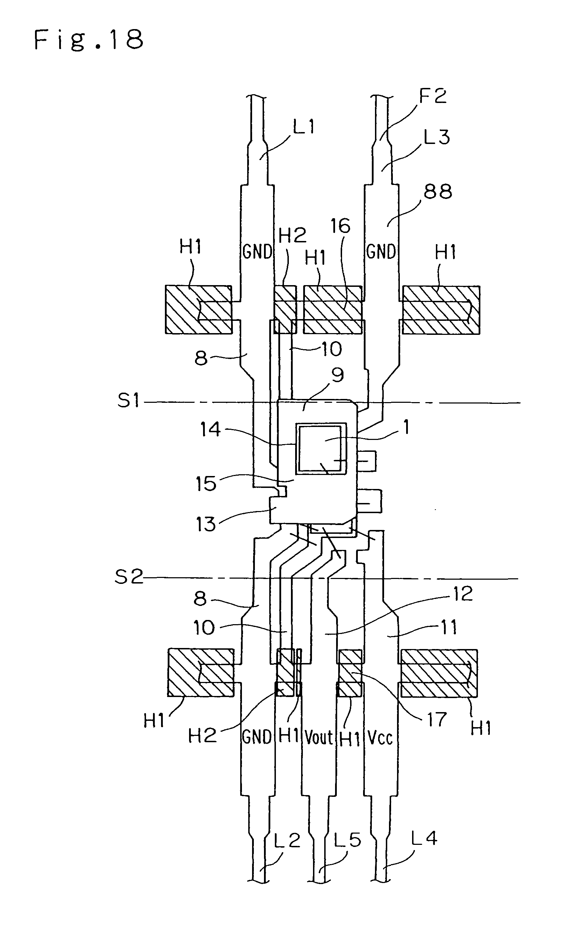

Next, with reference to the Figs. 15 to 18, which show the leadframe, the structure of the photodetector module M2 will be described along with the fabrication procedure thereof. Fig. 15 is a plan view of the leadframe, Fig. 16 is a plan view of the leadframe showing a portion thereof corresponding to a single photodetector module, Fig. 17 is a plan view of the leadframe as observed at one stage in the course of the assembly thereof, and Fig. 18 is a plan view of the leadframe as observed at another stage, different from the one shown in Fig. 17, in the course of the assembly thereof.

First, a leadframe FF as shown in Fig. 15 is prepared. Fig. 16 shows the shape of the leadframe F2 that is used in a single photodetector module.

As shown in Fig. 16, along one of the longer sides of the molding resin 3 extends an elongate fitting frame 8, and from both ends thereof protrude the leads L1 and L2. The leads L1 and L2 are used for connection to the ground potential (GND).

The fitting frame 8, along with an element mount frame 9 laid beside it that has a comparatively large area, forms a main frame 7. In the main frame 7, between the fitting frame 8 and the element mount frame 9, a gap 5 is formed in the shape of an elongate groove or cut. At both ends of the gap 5 are laid tie bars 10, 16, and 17 that tie the element mount frame 9 and the fitting frame 8 together.

Along the other of the longer sides of the molding resin 3 extends an elongate grounding frame 88, and from one end thereof protrudes the lead L3. The other end of the grounding frame 88 connects to the element mount frame 9. Likewise, along the other of the longer sides of the molding resin 3 extends a power supply frame 11, and from one end thereof protrudes the lead L4. Between the fitting frame 8 and the power supply frame 11 is laid a signal output frame 12, from one end of which protrudes the lead L5. The other end of the power supply frame 11 and the other end of the signal output frame 12 both reach close to the element mount frame 9.

In a position symmetric with the element mount frame 9 about the fitting frame 8, a shielding frame 15 is formed that has a window 14 formed therein and that has a comparatively large area. The shielding frame 15 is tied, via a tying portion 13, to a middle portion of the fitting frame 8.

The leads L1 and L3 are tied together by the tie bar 16, and the leads L2, L5, and L4 are tied together by the tie bar 17. The tie bars 10, 16, and 17 are, as will be described later, cut off by punching (indicated as hatched areas H1 and H2 in Figs. 15 and 18).

Fig. 17 shows the state in which the photodetector element 1 and the IC 2 for processing the signal therefrom are fixed on the element mount frame 9 with adhesive and the wires W1 and W8 are strung. After the wires are strung, as shown in Fig. 18, the tying portion 13 is bent so that the shielding frame 15 covers the element mount frame 9. Subsequently, along lines S1 and S2 shown in Fig. 18, the leads L1 to L5 are bent toward the rear face of the molding resin 3. Fig. 12 shows the state of the frame after the bending of the leads, as seen from in front.

Next, the leadframe is put in a molding frame filled with uncured resin, with the photodetector element 1 and the IC 2 facing down. When the resin cures, it forms the rectangular molding resin 3. The molding resin 3 holds the individual frames at regular intervals. This increases the mechanical strength of the photodetector module M1, and in addition makes it free from a change in the angle of the photodetector element 1.

Thereafter, the tie bars B and the tie bars 10, 16, and 17 are cut off in the hatched areas H1 and H2 shown in Figs. 15 and 18. Now, the fabrication of the photodetector module M2 shown in Figs. 10 to 14 is complete. The fitting frame 8 and the element mount frame 9 are cut apart from each other, but their relative positions are fixed by the molding resin 3, and their electrical connection is secured by the wire 8. The element mount frame 9 is fed with the ground potential via the lead L3, or via the lead L1 (L2) and the wire W8.

The tie bars 10, 16, and 17 may be left uncut so that the element mount frame 9 and the fitting frame 8 remain tied together by the tie bars 10, 16, and 17. Specifically, they are cut off only in the hatched area H1 shown in Fig. 18, and are left in the hatched area H2. This permits the element mount frame 9 and the fitting frame 8 to remain tied together by the tie bars 10, 16, and 17. This helps increase the mechanical strength of the element mount frame 9 and the fitting frame 8, and also helps save the trouble of securing electrical connection with the wire W8.

The photodetector module M2 structured as described above is mounted on a mount circuit board in a manner similar to that by which the photodetector module M1 is mounted.

With this photodetector module M2, the leads L2, L5, and L4, which are bent so as to protrude from the rear face of the molding resin 3, can be bent once again at a right angle so as to run in the direction opposite to where the leads L1 and L3 are located. This permits the leads L2, L5, and L4 to protrude from the bottom face of the molding resin 3 parallel to the rear face thereof. When the leads L2, L5, and L4 in this state are inserted into holes formed in the mount circuit board and fixed thereto, the photodetective surface of the photodetector module M2 lies perpendicular to the mount circuit board surface. When the photodetector module 2 receives light shone from a direction parallel to the mount circuit board surface, it produces a signal. When only three of the leads are connected in this way, the unused leads L1 and L3 may be cut off at the rear face of the molding resin 3.

In the first and second embodiments, the element mount frame 9 and the fitting frame 8 are kept at identical potentials. Alternatively, the element mount frame 9 and the fitting frame 8 may be kept at different potentials, and examples of such structures will be described below as a third and a fourth embodiment of the invention. Note that the third embodiment is a slightly modified version of the first embodiment, which basically addresses a four-lead structure, and the fourth embodiment is a slightly modified version of the second embodiment, which basically addresses a five-lead structure. Accordingly, the following description places emphasis on differences from the respective basic structures.

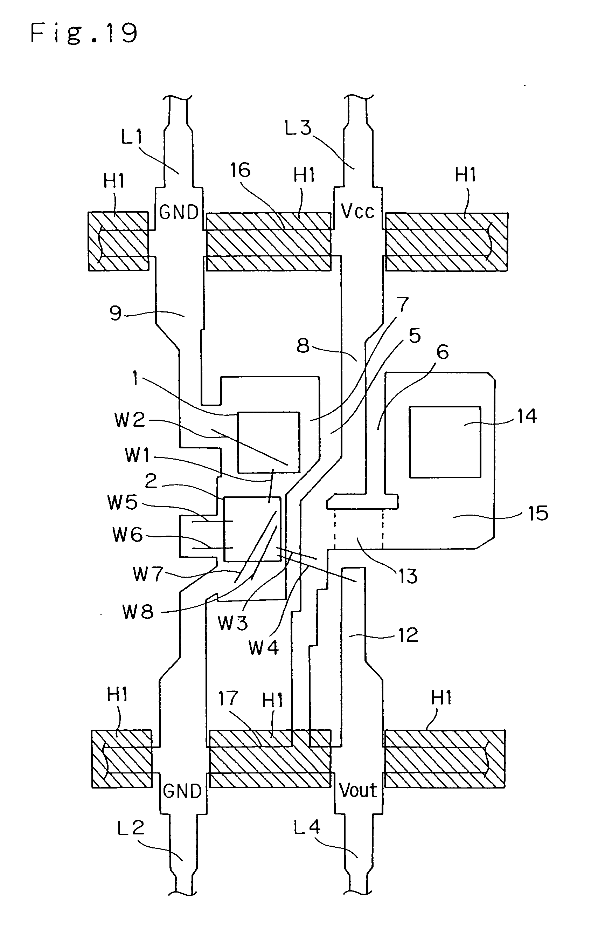

The photodetector module of the third embodiment of the invention is shown in Fig. 19. Fig. 19 is a plan view showing the leadframe as observed at one stage in the course of the assembly thereof. From both ends of an element mount frame 9 protrude leads L1 and L2. The leads L1 and L2 are used for connection to the ground potential (GND). Thus, the element mount frame 9 functions as a grounding frame.

The element mount frame 9, along with a fitting frame 8 laid beside it, forms a main frame 7. In the main frame 7, between the fitting frame 8 and the element mount frame 9, a gap 5 is formed in the shape of an elongate groove or cut. At both ends of the gap 5 are laid tie bars 16 and 17 that tie the element mount frame 9 and the fitting frame 8 together. The element mount frame 9 is so long as to cover the entire interval between the tie bars 16 and 17. That is, the element mount frame 9 is nearly as long as the gap 5. The tie bars 16 and 17 are cut off by punching in the hatched area H1 shown in Fig. 19.

From one end of the fitting frame 8 protrudes a lead L3. The lead L3 is used for connection to supplied power (Vcc). Beside the element mount frame 9 extends a signal output (Vout) frame 12, from one end of which protrudes a lead L4.

In a position symmetric with the element mount frame 9 about the fitting frame 8, a shielding frame 15 is formed that has a window 14 formed therein. The shielding frame 15 is tied, via a tying portion 13, to a middle portion of the fitting frame 8. Between the fitting frame 8 and the shielding frame 15, except in the tying portion 13, an elongate cut 6 is formed to separate the fitting frame 8 and the shielding frame 15 from each other. This helps give a smaller width to the tying portion 13, which functions as the very portion that is bent.

Fig. 19 shows the state in which the photodetector element 1 and the IC 2 for processing the signal therefrom are fixed on the element mount frame 9 with adhesive. As the adhesive here, both an insulating type and a conductive type are used as necessary. The photodetector element 1 and the IC 2 are connected together by a wire W1 for signal extraction. The photodetector element 1 and the element mount frame 9 are connected together by a wire W2 for grounding. The IC 2 and the fitting frame 8 are connected together by a wire W3 for power supply. The IC 2 and the signal output frame 12 are connected together by a wire W4 for signal output. The IC 2 and the element mount frame 9 are connected together by wires W5, W6, W7, and W8 for grounding.

After the wires are strung, in the same manner as shown in Fig. 9, the tying portion 13 is bent so that the shielding frame 15 covers the element mount frame 9. Subsequently, the leads L1 to L4 are bent toward the rear face of the molding resin 3. Next, the leadframe is put in a molding frame filled with uncured resin, with the photodetector element 1 and the IC 2 facing down. When the resin cures, it forms molding resin like the molding resin 3 shown in Fig. 1. The molding resin holds the individual frames at regular intervals.

Thereafter, the tie bars are cut off, and now the fabrication of a photodetector module having an outward appearance similar to that of the photodetector module M1 of the first embodiment is complete. The fitting frame 8 and the element mount frame 9 are cut apart from each other, but their relative positions are fixed by the molding resin.

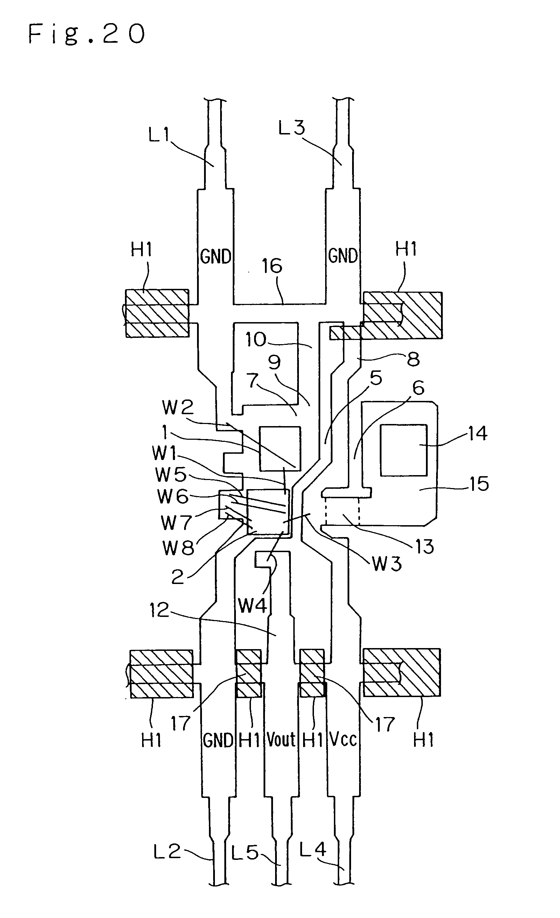

The photodetector module of the fourth embodiment of the invention is shown in Fig. 20. Fig. 20 is a plan view showing the leadframe as observed at one stage in the course of the assembly thereof. From both ends of an element mount frame 9 protrude leads L1 and L2. The leads L1 and L2 are used for connection to the ground potential (GND). Thus, the element mount frame 9 functions as a grounding frame.

The element mount frame 9, along with a fitting frame 8 laid beside it, forms a main frame 7. In the main frame 7, between the fitting frame 8 and the element mount frame 9, a gap 5 is formed in the shape of an elongate groove or cut. At both ends of the gap 5 are laid tie bars 16 and 17 that tie the element mount frame 9 and the fitting frame 8 together. The tie bars 16 and 17 are cut off by punching in the hatched area H1 shown in Fig. 20.

A lead L3 is laid beside the lead L1. The lead L3 is connected, via a tie bar 10 and the tie bar 16, to the element mount frame 9. The lead L3, like the leads L1 and L2, is used for connection to the ground potential (GND). From one end of the fitting frame 8 protrudes a lead L4. The lead L4 is used for connection to the supplied power (Vcc). Between the element mount frame 9 and the fitting frame 8 extends a signal output (Vout) frame 12, from one end of which protrudes a lead L5.

In a position symmetric with the element mount frame 9 about the fitting frame 8, a shielding frame 15 is formed that has a window 14 formed therein. The shielding frame 15 is tied, via a tying portion 13, to a middle portion of the fitting frame 8. The fitting frame 8 is, in a portion thereof near the tying portion 13, shaped nearly symmetrically about the tying portion 13. Thus, when the tying portion 13 is bent, the resulting stress is equally distributed between both sides of the tying portion 13. Between the fitting frame 8 and the shielding frame 15, except in the tying portion 13, an elongate cut 6 is formed to separate the fitting frame 8 and the shielding frame 15 from each other. This helps give a smaller width to the tying portion 13, which functions as the very portion that is bent.

Fig. 20 shows the state in which the photodetector element 1 and the IC 2 for processing the signal therefrom are fixed on the element mount frame 9 with adhesive. As the adhesive here, both an insulating type and a conductive type are used as necessary. The photodetector element 1 and the IC 2 are connected together by a wire W1 for signal extraction. The photodetector element 1 and the element mount frame 9 are connected together by a wire W2 for grounding. The IC 2 and the fitting frame 8 are connected together by a wire W3 for power supply. The IC 2 and the signal output frame 12 are connected together by a wire W4 for signal output. The IC 2 and the element mount frame 9 are connected together by wires W5, W6, W7, and W8 for grounding.

After the wires are strung, in the same manner as shown in Fig. 18, the tying portion 13 is bent so that the shielding frame 15 covers the element mount frame 9. Subsequently, the leads L1 to L5 are bent toward the rear face of the molding resin 3. Next, the leadframe is put in a molding frame filled with uncured resin, with the photodetector element 1 and the IC 2 facing down. When the resin cures, it forms molding resin like the molding resin 3 shown in Fig. 10. The molding resin holds the individual frames at regular intervals.

Thereafter, the tie bars are cut off, and now the fabrication of a photodetector module having an outward appearance similar to that of the photodetector module M2 of the second embodiment is complete. The fitting frame 8 and the element mount frame 9 are cut apart from each other, but their relative positions are fixed by the molding resin.

In the third and fourth embodiments, the shielding frame 15, which is kept at the supplied power potential (a potential different from the ground potential), shuts off electromagnetic noise.

It should be understood that the invention may be carried out in any other manner than specifically described above as embodiments, and that many modifications and variations are possible within the scope and spirit of the invention.

### Industrial applicability

The present invention find wide application in photodetector modules of the type that has a photodetector element fixed on a leadframe and sealed in a resin molding.

## Claims

1. A leadframe comprising an element mount frame, a fitting frame that is laid beside the element mount frame with a gap left in between, and a shielding frame that is tied via a tying portion to the fitting frame and that can be brought into such a state as to cover the element mount frame.

2. The leadframe of claim 1,
wherein the tying portion is provided at both ends of the gap.

3. The leadframe of claim 1,
wherein the element mount frame and the fitting frame are separate.

4. The leadframe of one of claims 1 to 3,
wherein the fitting frame is, in a portion thereof near the tying portion, shaped symmetrically about the tying portion.

5. A photodetector module comprising a photodetector element, an element mount frame on which the photodetector element is mounted, a fitting frame that is laid beside the element mount frame with a gap left in between, a shielding frame that is tied via a tying portion to the fitting frame and that can be brought into such a state as to cover the element mount frame, and molding resin in which the element mount frame and the fitting frame are sealed.

6. The photodetector module of claim 5,
wherein the element mount frame and the shielding frame are kept at an equal potential.

7. The photodetector module of claim 5,
wherein the element mount frame and the shielding frame are kept at different potentials.

8. The photodetector module of claim 5,
wherein a circuit element that processes a signal from the photodetector element is mounted on the element mount frame.

9. The photodetector module of claim 5,
wherein the element mount frame and the gap have nearly equal lengths.
